Europäisches Patentamt

European Patent Office

Office européen des brevets

(11) Publication number: **0 180 397 B1**

(12) **EUROPEAN PATENT SPECIFICATION**

(45) Date of publication of patent specification: **29.07.92**  (51) Int. Cl.⁵: **C01B 33/02**

(21) Application number: **85307618.0**

(22) Date of filing: **22.10.85**

(54) **Method and apparatus for the production of polycrystalline silicon.**

(30) Priority: **24.10.84 JP 223177/84**

(43) Date of publication of application:
**07.05.86 Bulletin 86/19**

(45) Publication of the grant of the patent:
**29.07.92 Bulletin 92/31**

(84) Designated Contracting States:
**DE FR GB SE**

(56) References cited:
**DE-A- 2 854 707**       **DE-A- 2 919 086**
**FR-A- 2 111 630**       **GB-A- 853 729**
**US-A- 2 999 735**       **US-A- 3 057 690**
**US-A- 3 142 584**       **US-A- 3 146 123**

(73) Proprietor: **Ishizuka, Hiroshi
19-2, Ebara 6-chome Shinagawa-ku
Tokyo(JP)**

(72) Inventor: **Ishizuka, Hiroshi
19-2, Ebara 6-chome Shinagawa-ku
Tokyo(JP)**

(74) Representative: **Pendlebury, Anthony et al
PAGE, WHITE & FARRER 54 Doughty Street
London WC1N 2LS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a method and apparatus for the production of polycrystalline silicon, by, in particular, the thermal decomposition of a silicon hydride such as silane.

It is known, for example from DE-A-1176103 (which discloses the features of the precharacterising portion of claim 1), to produce polycrystalline silicon materials by the decomposition of silicon hydride, such as monosilane ($SiH_4$) or disilane ($Si_2H_6$), on a heated filament of pure silicon. The process is conducted in a stainless steel vessel with the wall of the vessel being water-cooled intensively almost to room temperature, thereby suppressing a wasteful decomposition and deposition of powdery silicon in the vessel other than on the filament substrate, as well as preventing contamination of the growing silicon by any readily volatile ingredient of the vessel material. The filament, on the other hand, has to be heated to elevated temperatures of the order of 900°C to allow the decomposition to proceed at a practical rate. This results inevitably in rather a high power consumption relative to the mass of the product, with a very limited part of the power input being effective for sustaining the process, while the balance is wastefully removed by the coolant water.

It is also known to produce silicon from the decomposition of chlorosilanes. US 3142584 discloses a method of production of silicon by precipitation from a reaction gas mixture of silicochloroform and hydrogen in a quartz bell having a metallic closure structure. The carrier substrate is maintained at a temperature above 900°C, whilst the closure structure is cooled by circulation of a coolant liquid therethrough, which coolant liquid has a boiling point of 100 to 750°C. GB 853729 discloses a method for producing silicon by decomposition of a silicon halide in the gas phase and deposition on an incandescent silicon carrier member at 1100°C in a heated glass or quartz vessel. FR-A-2111630 teaches methods of production of silicon by decomposition of various chlorosilanes in a quartz vessel at less than 300-350°C on a substrate maintained at a temperature below 800°C. Decomposition of the chlorosilanes produce, besides hydrogen and the principal product of silicon, hydrochloric acid, whose high aggressiveness necessitates a reaction vessel of a chemically resistant material, typically, quartz as is employed in the above-mentioned references. However, because of contamination of the silicon product, the use of metallic materials for the vessel, such as ordinary steels for the vessel is prevented.

From DE-A-2854707 (which discloses the features of the precharacterising portion of claim 3) it is also known that silicon can be produced from trichlorosilane. The process is conducted in a bell of silver or silver-plated steel, which is cooled with water or gas. The temperature range of 70 to 200°C is mentioned as especially favourable for the inner side of the bell wall during the silicon deposition. As the initial material yields by decomposition hydrochloric acid which is aggressive to the metallic wall, increasingly so with temperature. Apparently it may be difficult to use higher temperatures for decreasing the gradient and thus heat loss in this case.

Also, the deposition substrate commonly is made of a high purity silicon filament, which at temperatures less than about 400°C exhibits rather a high electrical resistance and, thus, needs an increased voltage or a specialized preliminary heating means in order to reach an operating temperature over such range.

Therefore, one of the principal objects of the present invention is to provide a novel technique which has been eliminated of the above problems.

According to the invention there is provided a method for the production of polycrystalline silicon, comprising: heating a deposition substrate in a reaction vessel of metal, bringing in gaseous state a silicon hydride selected from mono- and disilane into the reaction vessel, decomposing the silicon hydride, and producing a deposit of silicon on the substrate, characterised in that the wall of the vessel is maintained at a temperature of from 300 to 450°C, which is from 100 to 700°C lower than the temperature of the heated substrate.

In the method of the invention applicable silicon hydrides may include mono- or di-silanes which do not form chlorine or other substances which are aggressive towards steel, in order that steel can be used as vessel material.

The vessel wall is heated at temperatures within the above said range and, preferably, to a temperature which is from 300 to 500°C lower than the temperature of the deposition substrate which is at red heat.

The present invention also provides an apparatus for the production of polycrystalline silicon, comprising: a reaction vessel of metallic material which is closed with a detachable closure, an inlet and an outlet for gas which are connected to the vessel, a jacket which is arranged entirely over the vessel to provide an interspace therearound as well as over the closure, and an inverse U-shaped deposition substrate of electrically conductive material which has a pair of vertical portions extending from the closure within the vessel, characterised by a closed circuit for a gas comprising a part of the interspace, a two-way temperature controlling means for heating and cooling the gas which is provided in the circuit, and a partition of which hollow wings comprise an inner cavity which is in communication with the temperature controlling means, said wings being arranged between and separating an adjacent pair of the vertical portions of the substrate.

A neutral gas such as, preferably, argon or hydrogen, can be held in the space at a pressure greater than that of the atmosphere, in order better to suppress any air leakage and to remove the heat from the vessel wall during the deposition process.

The temperature controlling means may comprise an electrical heater, which may be of conventional design, arranged either within the interspace or in the closed circuit, and a heat exchanger with a water coolant.

One or more deposition substrates may be arranged to extend axially in the reaction chamber with the upper or lower end or ends thereof being fixed to an end of the chamber. When the substrates or substrate portions of axial construction are arranged adjacent to and parallel with each other, they can be separated with a hollow insulation partition which has inwards a cavity in communication with the temperature controlling means and which extends along the substrates or substrate portions, so that no other part of the space within the vessel is hot enough to produce an appreciable proportion of pulverized deposit. The partition cavity conveniently can be united with the interspace within the jacket which surrounds the reaction vessel as a whole. Preferably, the cavity as well as the intespace is filled with an inert gas at a temperature which is regulated to a particular level, so as to allow the partition to be kept at a temperature which is close to those around the outside wall.

The gas spaces thus provided around and inside the reaction vessel can be used to preheat the deposition substrate to a temperature of the order of 400°C, at which temperature the electrical resistivity of the substrate substantially is decreased, by passing a heated gas through those spaces. This feature allows the heating of the substrate to be started with a decreased voltage without resort to an additional specialized heater which has heretofore been indispensable. As the reaction system used in the invention is not aggressive towards metallic materials, a wide variation of metals is available for constructing the reaction vessel, provided that the metallic material used does not comprise any ingredients which are highly volatile at temperatures around 500°C. Some grades of stainless steel are preferred examples since they provide simplified maintenance of the apparatus.

Embodiments of the present invention will now be described by way of example only with refernce to the accompanying drawings, in which:-

Figure 1 shows an elevational section of an apparatus for producing polycrystalline silicon according to a first embodiment of the invention;

Figure 2 shows an elevational section of an apparauts for producing polycrystalline silicon according to a second embodiment of the invention; and

Figure 3 is a sectional horizontal view taken along line A-A in Figure 2.

The Inventor has found and based this invention on the fact that monosilane starts to decompose at 380°C, approximately, and the rate of decomposition increases only very slowly to a level at some 450°C which is less than 1/2000 that at 700°C. Consequently, maintaining the temperature of the wall at around 400°C will allow only a practically negligeable proportion of silicon deposit to be formed other than on the filament which is heated to 800°C or more.

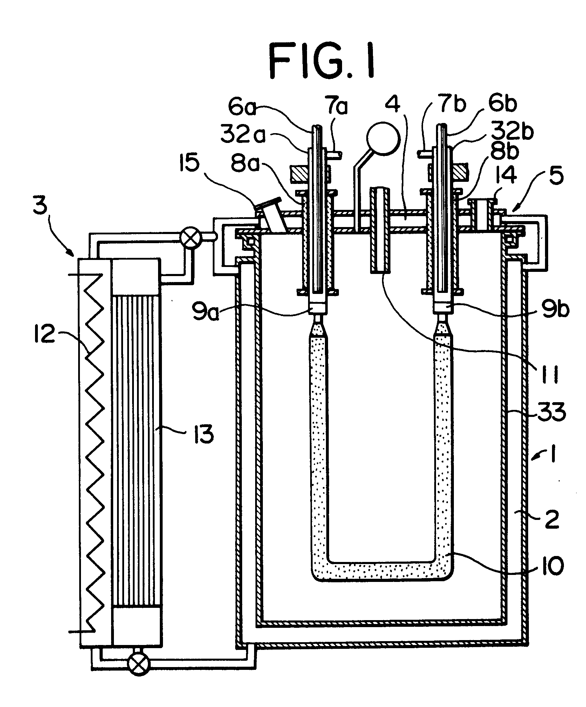

Referring to Figure 1, a reaction vessel designated generally at 1 has a substantially cylindrical, closed construction, and is surrounded by a jacket 2, which is connected by piping at its upper and lower ends with the inlet and outlet of a temperature regulator 3. The reaction vessel 1 is closed at its upper end with a lid 5, which is covered with a jacket 4, through which a pair of electrode assemblies are arranged to extend into the vessel. Each of the electrode assemblies comprises for cooling purposes a hollow body 32a, 32b of a highly conductive metal, through which water is allowed to pass via a respective inlet 6a, 6b and outlet 7a, 7b, and for insulation, a respective sleeve 8a, 8b. The assemblies support at joints 9a and 9b a round rod 10 of high purity silicon in a U shape, in this particular example, to serve as a deposition substrate. Silicon hydride is supplied to the vessel through an introduction nozzle 11, and is decomposed on and around the substrate to yield silicon which deposits thereon. During the process the vessel wall 33 is kept at temperatures of from 100 to 450°C by passing through jackets 2 and 4 on the vessel wall 33 and lid 5, a gas, which is temperature regulated in the temperature regulator 3 which allows the gas to circulate through a heater 12 or a cooler 13 as required. A degassing port 14 is arranged in the lid 5 for removal of the hydrogen byproduct, as well as evacuation prior to the deposition process. The process can be observed through a peephole 15 in the lid 5.

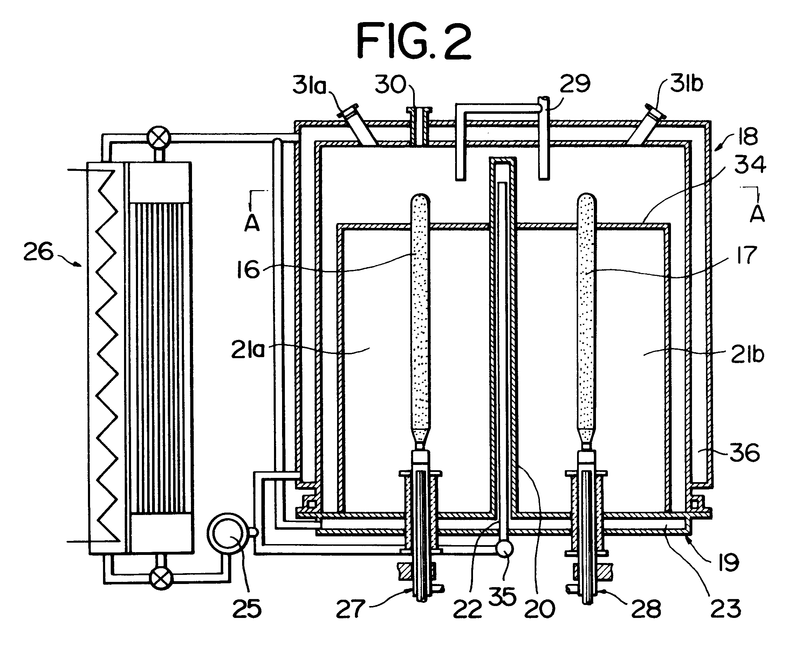

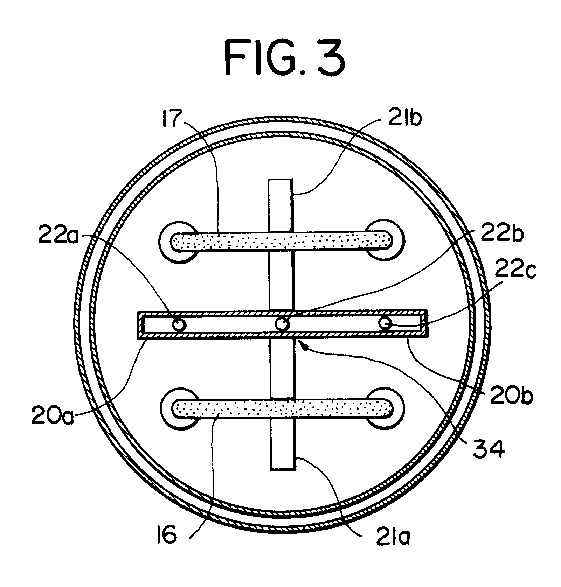

In Figures 2 and 3, which show a further example of an apparatus for producing polycrystalline silicon, two deposition substrates 16 and 17 are arranged in a single reaction vessel 18. The setup is basically the same as that in Figure 1, with a modification such that the substrates are supported above a lid 19 covering the bottom of the vessel 18. The vertical portions of the substrates 16 and 17 are separated over the most of their length by a partition 34 which comprises a crosswise extending set of hollow wings 20a and 20b interposed between the two substrates and wings 21a and 21b between the vertical portions of each substrate. The partition cavities in each direction are preferably sectioned for an orderly circulation of the gas and thus an improved temperature controllability, by inserting a pipe or pipes 22a and 22b so as effectively to lead the gas upwards in the partition. Such pipe or pipes are joined to a main 35, while the partition cavity is communicated at its bottom with the jacket 23. A gas circuit is so formed that the gas as driven by a blower 25 is forced through piping into the guide pipes 22a, 22b and 22c in the partition as well as the vessel wall jacket 36. The gas coming out from the jackets 23 and 36 is allowed to enter the temperature regulator 26. The partition should have height and width dimensions large enough to block the substantial part of the heat radiation from the vertical substrate portion to which it is closely adjacent. The electrode assemblies have a cooling and insulation arrangement, which may be of the same construction as those shown in Figure 1.

The starting material of silicon hydride is introduced through a forked nozzle 29, and the hydrogen byproduct is removed through a port 30, which can also serve for evacuation prior to the deposition process. The deposition process can be monitored through peepholes 31a and 31b in the top of the vessel 18.

Example 1

An arrangement basically illustrated in Figure 1 was used. The cylindrical vessel of heat resistant steel (equivalent to AISI 316) measured 1.2 m in I.D. and 2.0 m in length and had a 10 cm spaced jacket over the whole surface. The temperature regulator was an electrically heatable and water coolable type. A 5 mm diameter substrate of high purity silicon comprised two vertical portions 120 cm long each, and a horizontal portion 60 cm long and joined thereto at each end so as to form a U-shape. The jacket was charged with heated argon to heat the vessel and, thus, the substrate to 500°C as measured on the vessel wall. The power supply to the substrate was started when a temperature of some 450°C had been reached. The reaction was caused by supplying a mixed gas with a $SiH_4/H_2$ ratio of 0.1 onto the substrate which was maintained at some 900°C, while cooling the vessel wall to levels around 400°C.

The substrate grew at rates between 8-10 $\mu$m/min. and to a diameter of 100 mm after some 90 hours of the process. The period is only almost half as long, with a power consumption decreased by as much as 70% to obtain a product of comparable quality, relative to conventional methods with the reaction vessel being cooled to room temperatures.

Example 2

The method of Example 1 was repeated except that the substrate was heated instead to some 1,000°C. At a reaction rate increased to twice that in Example 1, the product still exhibited a similarily high quality.

Example 3

The method of Example 1 was repeated but until a product diameter of 150 mm was reached. The required time was about 130 hours, with a decrease to almost 45% that required with conventional methods. The power consumption was reduced by 75%, with the product quality similarly high.

**Claims**

1. A method for the production of polycrystalline silicon, comprising: heating a deposition substrate (16,17) in a reaction vessel (18) of metal, bringing in gaseous state a silicon hydride selected from mono- and disilane into the reaction vessel, decomposing the silicon hydride, and producing a deposit of silicon on the substrate, characterised in that the wall of the vessel is maintained at a temperature of from 300 to 450°C, which is from 100 to 700°C lower than the temperature of the heated substrate.

2. A method according to Claim 1, in which the temperature of the wall is from 300 to 500°C lower than the temperature of the heated substrate.

3. An apparatus for the production of polycrystalline silicon, comprising: a reaction vessel (18) of metallic material which is closed with a detachable closure (19), an inlet (29) and an outlet (30) for gas which are connected to the vessel, a jacket (23,36) which is arranged entirely over the vessel to provide an interspace therearound as well as over the closure (19), and an inverse U-shaped deposition substrate (16,17) of electrically conductive material which has a pair of vertical portions extending from the closure within the vessel, characterised by a closed circuit for a gas comprising a part of the interspace, a two-way temperature controlling means (26) for heating and cooling the gas which is provided in the circuit, and a partition (34) of which hollow wings (21a,21b) comprise an inner cavity which is in communication with the temperature controlling means, said wings being arranged between and separating an adjacent pair of the vertical portions of the substrate.

4. An apparatus according to claim 3, comprising a plurality of deposition substrates (16,17) and in which the vertical portions of adjacent substrates (16,17) are separated by the hollow wings (20a,20b) of the partition (34).

**Revendications**

1. Méthode de production de silicium polycristallin, comportant les phases suivantes: on chauffe un substrat de dépôt (16,17) contenu dans un réacteur (18) en métal, on introduit dans le réacteur un hydrure de silicium à l'état gazeux choisi dans un groupe comprenant le mono- et le disilane, on décompose l'hydrure de silicium, et on produit un dépôt de silicium sur le substrat, caractérisée en ce qu'on maintient la paroi du réacteur à une température comprise entre 300 et 450° C, cette température étant inférieure de 100 à 700° C à la température à laquelle on chauffe le substrat.

2. Méthode selon la revendication 1, dans laquelle la température de la paroi est inférieure de 300 à 500° C à la température à laquelle on chauffe le substrat.

3. Appareil pour produire du silicium polycristallin, comportant: un réacteur (18) ayant un corps en métal fermé par un couvercle amovible (19), une entrée (29) et une sortie (30) pour un gaz qui sont raccordées au réacteur, une double enveloppe (23,36) qui recouvre entièrement le réacteur de manière à constituer un volume auxiliaire d'une certaine épaisseur tout autour du réacteur ainsi que sur le couvercle (19), et un substrat de dépôt (16,17) en matière conductrice de l'électricité, ayant la forme d'un U à l'envers avec deux branches verticales partant du couvercle et s'étendant à l'intérieur du réacteur, caractérisé en ce qu'il comporte un circuit pour un gaz qui comprend une partie du volume auxiliaire, un système à double effet de régulation de température (26) pour chauffer et refroidir le gaz qu'on introduit dans le circuit, et une cloison de séparation (34) ayant des ailes creuses (21a,21b) dont la cavité interne est en communication avec le système de régulation de température, ces ailes étant disposées entre deux parties verticales adjacentes du substrat, de manière à séparer ces deux parties.

4. Appareil selon la revendication 3, comportant plusieurs substrats de dépôt (16,17), et dans lequel les parties verticales des substrats adjacents (16,17) sont séparées par les ailes creuses (20a, 20b) de la cloison (34).

**Patentansprüche**

1. Verfahren für die Herstellung von polykristallinem Silikon, das einschließt: Erhitzung eines Sedimentationssubstrates (16,17) in einem Reaktionsgefäß (18) aus Metall, das Einbringen eines von Mono- und Disilan getrennten Silikonhydrids in gasförmigem Zustand in das Reaktionsgefäß, Zerlegen des Silikonhydrids und Herstellen eines Niederschlags aus Silikon auf dem Substrat, dadurch gekennzeichnet, daß die Wand des Gefäßes bei einer Temperatur von 300 bis 450° C gehalten wird, was 100 bis 700° C niedriger ist als die Temperatur des erhitzten Substrates.

2. Verfahren nach Anspruch 1, bei welchem die Temperatur der Wand um 300 bis 500° C niedriger ist als die Temperatur des erhitzten Substrates.

3. Vorrichtung für die Herstellung von polykristallinem Silikon, die einschließt: ein aus metallischem Material bestehendes Reaktionsgefäß (18), welches durch einen abnehmbaren Verschluß (19) verschlossen ist, einen Einlaß (29) und einen Auslaß (30) für Gas, welche mit dem Gefäß verbunden sind, eine Ummantelung (23,36), welche so angeordnet ist, daß sie sich über das gesamte Gefäß erstreckt, um sowohl drumherum als auch über dem Verschluß (19) einen Zwischenraum zu bilden und ein umgekehrtes U-förmiges Sedimentationssubstrat (16,17) aus elektrisch leitendem Material, welches ein Paar von vertikalen Teilen besitzt, die sich von dem Verschluß im Inneren des Gefäßes erstrecken, dadurch gekennzeichnet, daß ein geschlossener Kreislauf für ein Gas vorgesehen ist, der einen Teil des Zwischenraums einschließt, ein zwei-Weg-Temperaturkontrollmittel (26) für das Erhitzen und das Kühlen des Gases, welches in dem Kreislauf vorgesehen ist und eine Trennwand (34), deren Hohlflügel (21a,21b) einen inneren Hohlraum einschließen, welcher in Verbindung steht mit dem Temperaturkontrollmittel, wobei diese Flügel zwischen dem angrenzenden Paar der vertikalen Teile des Substrats angeordnet sind und diese trennen.

4.  Vorrichtung nach Anspruch 3, die eine Vielzahl von Sedimentationssubstraten (16,17) einschließt und in welcher die vertikalen Teile des angrenzenden Substrates (16,17) durch die Hohlflügel (20a,20b) der Trennwand (34) getrennt sind.

# FIG. 1

FIG.2

# FIG. 3